# EUROPÄISCHE PATENTSCHRIFT

(11) **EP 1 424 730 B1**
(45) Veröffentlichungstag und Bekanntmachung des Hinweises auf die Patenterteilung: **08.10.2008**
(21) Anmeldenummer: 02026691.2
(22) Anmeldetag: 29.11.2002
(51) Int. Cl.: H01L 23/485, H01L 23/528

(54) **Halbleiterchip mit Anschlusskontaktflächen und Anordnung eines solchen Halbleiterchips auf einem Träger**
Semiconductor device with contact pads and arrangement of such a semiconductor chip on a substrate
Dispositif semi-conducteur avec des plots de contact et disposition d'une telle puce de semi-conducteur sur un substrat

(43) Veröffentlichungstag der Anmeldung: 02.06.2004
(73) Patentinhaber: Infineon Technologies AG, 81669 München (DE)
(72) Erfinder: Hübner, Holger, 85598 Baldham (DE)
(74) Vertreter: Epping - Hermann - Fischer

(56) Entgegenhaltungen:
- GB-A- 2 174 543
- US-A- 4 948 754
- US-A- 5 082 802
- US-A- 5 977 641
- US-B1- 6 268 642
- PATENT ABSTRACTS OF JAPAN vol. 2000, no. 13, 5. Februar 2001 (2001-02-05) -& JP 2000 299406 A (SANYO ELECTRIC CO LTD), 24. Oktober 2000 (2000-10-24)

## Beschreibung

Die vorliegende Erfindung betrifft eine Chipkontaktierung mit minimalem Platzbedarf und der Möglichkeit einer Variation der Form der Kontakte.

Die Kontaktierung von Halbleiterchips erfolgt üblicherweise mittels Drahtbondung oder mittels Lotkugeln (im Fall der Flip-Chip-Montage). In beiden Fällen werden typischerweise 100 × 100 µm² große Flächen (Pads) in der obersten Metalllage der Verdrahtung erzeugt, auf die entweder die Drähte geschweißt oder die Lotkugeln aufgebracht werden. Für einen einzigen Kontakt wird so ein riesiger Flächenanteil verbraucht, und zwar in einer Metallebene, die eigentlich zur Verdrahtung des Chips und damit für wesentlich komplexere schaltungstechnische Aufgaben gebraucht wird. Außerdem muss bei der heute verwendeten Kupfermetallisierung eine zusätzliche Schichtebene aus AlSiCu aufgebracht werden, um die für die Bondung erforderliche Oberfläche bereitstellen zu können. Bei den genannten Herstellungsverfahren sind die Form und die Größe der Kontaktfläche festgelegt und auf der gesamten Chipoberfläche gleichartig. Die Kontakte können daher nicht an die individuellen Erfordernisse angepasst werden.

In der US 6,268,642 B1 ist eine Bauelementstruktur beschrieben, bei der Anschlusskontakte auf einer Metallschicht vorhanden sind, die oberhalb einer Passivierungsschicht aufgebracht ist. In der Passivierungsschicht sind Öffnungen vorhanden, in denen die Metallschicht die darunter vorhandenen Metallflächen der obersten Metallisierungsebene berührt. Die Anschlusskontaktflächen sind streifenförmig und mit periodisch wiederkehrenden Abmessungen dargestellt.

In der JP 2000 299406 A sind Verdrahtungsebenen oberhalb einer Passivierungsschicht beschrieben. Die obere Verdrahtungsebene ist ihrerseits durch passivierendes Material abgedeckt, in dem sich Durchkontaktierungen zu oberseitigen Lotkugeln befinden. Es handelt sich hier um eine über den Verdrahtungsebenen vorhandene Umverdrahtung.

In der US 4,948,754 ist ein Herstellungsverfahren für Bauelemente beschrieben, bei dem Kontaktkugeln auf der Oberseite einer Passivierungsschicht angeordnet werden. Die Passivierungsschicht wird zur Einebnung der Halbleiteroberseite aufgebracht; es sind keine mehrlagigen Verdrahtungen vorhanden.

In der US 5,977,641 ist ein Halbleiterbauelement mit Lotkugeln auf Metallschichten beschrieben. Die Metallschichten sind auf einer Isolationsschicht angeordnet, in deren Öffnungen die Metallschichten Kontaktflächen der Elektroden des Bauelementes kontaktieren.

Aufgabe der vorliegenden Erfindung ist es, eine Kontaktierung für Halbleiterchips mit minimalem Platzbedarf und hoher Zuverlässigkeit bei der Montage von Chipstapeln anzugeben.

Diese Aufgabe wird ausgehend von einem aus US 6,268,642 B1 bekannten Halbleiterchip mit den Merkmalen des Oberbegriffs von Anspruch 1 mit dem Halbleiterchip mit den Merkmalen des Anspruchs 1 bzw. mit einer Anordnung mit einem Halbleiterchip mit den Merkmalen des Anspruchs 5 gelöst. Ausgestaltungen ergeben sich aus den abhängigen Ansprüchen.

Der Halbleiterchip besitzt in einer an sich bekannten Weise eine oder mehrere Verdrahtungsebenen, die aus jeweiligen strukturierten Metallschichten gebildet sind, zwischen denen Zwischenmetalldielektrika angeordnet sind. Durchkontaktierungen durch diese Zwischenmetalldielektrika stellen vertikale leitende Verbindungen der Verdrahtungsebenen dar. Die Oberseite des Halbleiterchips ist mit einer Passivierungsschicht bedeckt.

Die Anschlusskontaktflächen sind auf der Oberseite dieser Passivierungsschicht angeordnet. In der Passivierungsschicht sind weitere Durchkontaktierungen vorhanden, mit denen die für externen elektrischen Anschluss vorgesehenen Anteile einer obersten Metallisierungsschicht elektrisch leitend mit den Anschlusskontaktflächen verbunden sind.

Wenn zur Erzeugung der Kontaktflächen das an sich bekannte SOLID-Verfahren benutzt wird, können die Durchkontaktierungen zwischen der obersten Metallisierungsebene der Verdrahtungen und den Anschlusskontaktflächen mit einem kleinen Durchmesser unterhalb 1 µm ausgebildet werden.

Die Größen und Formen der Durchkontaktierungen zu den Anschlusskontaktflächen und die Größe der Anschlusskontaktflächen selbst können entsprechend den mechanischen, thermischen und elektrischen Erfordernissen gestaltet werden. Die Größe der Anschlusskontaktflächen kann insbesondere an den zu übertragenden Strom oder die benötigten HF-Eigenschaften angepasst werden. Die Montage des Halbleiterchips auf einem Träger, z. B. einem Substrat oder Leadframe, ist wesentlich vereinfacht.

Es folgt eine genauere Beschreibung von Beispielen des Halbleiterchips und Anordnungen des Halbleiterchips auf einem Träger anhand der Figuren 1 bis 3.

Die Figur 1 zeigt eine erfindungsgemäße Ausgestaltung der Anschlusskontaktflächen.

Die Figur 2 zeigt ein Beispiel eines Halbleiterchips im Querschnitt.

Die Figur 3 zeigt ein Beispiel einer Anordnung des Halbleiterchips auf einem Träger im Querschnitt.

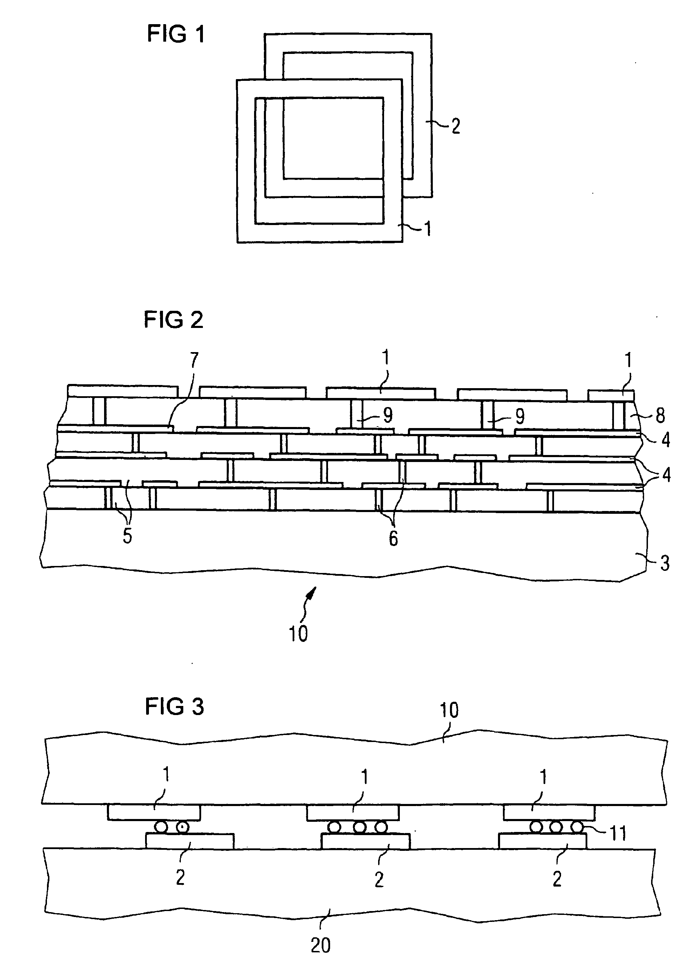

Die in der Figur 1 dargestellte Ausgestaltung mit ringförmig oder rahmenförmig ausgebildeten Anschlusskontaktflächen 1, 2 erhöht die Kontaktsicherheit, da die Anschlusskontaktflächen sich in einem ringförmigen oder rahmenförmigen Bereich oder zumindest, wie in der Figur 1 dargestellt, in zwei voneinander getrennten Bereichen berühren, in denen die Rahmen einander überschneiden.

In der Figur 2 ist ein Halbleiterchip im Querschnitt dargestellt. Ein Halbleiterkörper 3 enthält die Bauelemente der Schaltung. Auf der Oberseite befinden sich in diesem Beispiel drei Verdrahtungsebenen 4, die jeweils durch strukturierte Metallschichten gebildet sind. Dazwischen sind jeweils Dielektrikumschichten 5 angeordnet, die für eine elektrische Isolation zwischen den Verdrahtungsebenen sorgen. Vertikale leitende Verbindungen sind durch die Durchkontaktierungen 6 gebildet.

Über der obersten Verdrahtungsebene 7 befindet sich eine Passivierungsschicht 8. In der Passivierungsschicht 8 sind nicht wie in herkömmlicher Weise Öffnungen vorgesehen, in denen die Anschlusskontaktflächen der obersten Verdrahtungsebene nach außen zugänglich sind. Statt dessen sind bei diesem Halbleiterchip in der Passivierungsschicht 8 weitere Durchkontaktierungen 9 angeordnet.

Auf der Oberseite der Passivierungsschicht 8 sind die Anschlusskontaktflächen 1 angeordnet, die auf diese Weise unabhängig von der Struktur der Verdrahtungsebenen 4, insbesondere unabhängig von der Struktur der obersten Verdrahtungsebene 7 ausgebildet sein können. Das ist in dem Beispiel der Figur 2 dadurch angedeutet, dass die Anschlusskontaktflächen 1 jeweils mit denselben seitlichen Abmessungen eingezeichnet sind.

In der Figur 3 ist eine für Flip-Chip-Montage geeignete Anordnung des Halbleiterchips 10 auf einem Träger 20 im Querschnitt dargestellt. Es ist in dieser Figur 3 erkennbar, dass die Anschlusskontaktflächen 1 und die weiteren Anschlusskontaktflächen 2 des Trägers 20 nicht genau übereinander angeordnet zu sein brauchen. Wegen der Anordnung der Anschlusskontaktflächen 1 des Halbleiterchips 10 auf der Passivierungsschicht 8 ist es möglich, diese Anschlusskontaktflächen 1 so auszubilden, dass auch bei einer seitlichen Verschiebung des Halbleiterchips 10 bei der Montage auf dem Träger 20 die Anschlusskontaktflächen 1 des Halbleiterchips 10 mit den weiteren Anschlusskontaktflächen 2 des Trägers 20 für eine sichere elektrische Verbindung zumindest ausreichend weit überlappen. In der Figur 3 ist schematisch die Anordnung von Lotkugeln 11 zwischen den Anschlusskontakten eingezeichnet.

Wenn nicht ein Lotverfahren angewendet werden soll, sondern ein herkömmliches Drahtbonden auf Anschlusskontaktflächen aus Kupfer, können vor dem Bonden die Kupferflächen vergoldet werden.

Die Vorteile des erfindungsgemäßen Halbleiterchips und der Anordnung sind insbesondere, dass die Fenster in der Passivierungsschicht wie normale Durchkontaktierungen (Vias) dimensioniert werden können. Sie können damit bis zu 1 µm² klein sein. Entsprechend klein können die elektrischen Anschlüsse der Durchkontaktierungen in der obersten Verdrahtungsebene dimensioniert werden. Die Größe der einzelnen Kontakte sind frei wählbar. Sie können je nach den geometrischen und technischen Erfordernissen individuell gestaltet werden. Die gesamte oberste Verdrahtungsebene steht für die Chipverdrahtung zur Verfügung.

Mit dem Halbleiterchip ist es möglich, die Kupfermetallisierungen der Verdrahtungen direkt zu kontaktieren, ohne dass eine zusätzliche AlSiCu-Schicht aufgebracht werden muss. Die Anschlusskontaktflächen können eine von einer Struktur jeder Verdrahtungsebene abweichende und zumindest in einer Richtung periodisch wiederkehrende Abmessung aufweisen. Das Design der Anschlusskontaktflächen ist daher von den jeweiligen integrierten Schaltungen weitgehend unabhängig.

## Patentansprüche

1. Halbleiterchip mit
mindestens einer Verdrahtungsebene (4), mindestens einem Zwischenmetalldielektrikum (5) und Durchkontaktierungen (6) sowie mit
Anschlusskontaktflächen (1) zur externen elektrischen Verbindung,
wobei auf einer obersten Verdrahtungsebene (7) eine Passivierungsschicht (8) vorhanden ist, die mit weiteren Durchkontaktierungen (9) versehen ist, und
auf der Passivierungsschicht (8) die Anschlusskontaktflächen (1) angeordnet und mit den betreffenden weiteren Durchkontaktierungen (9) verbunden sind,
**dadurch gekennzeichnet, dass**
mindestens eine Anschlusskontaktfläche (1) ringförmig oder rahmenförmig ausgebildet ist.

2. Halbleiterchip nach Anspruch 1, bei dem
die Anschlusskontaktflächen (1) eine von einer Struktur jeder Verdrahtungsebene (4) abweichende und zumindest in einer Richtung periodisch wiederkehrende Abmessung aufweisen.

3. Halbleiterchip nach Anspruch 1 oder 2, bei dem
mindestens eine Anschlusskontaktfläche (1) streifenförmig ausgebildet ist.

4. Halbleiterchip nach einem der Ansprüche 1 bis 3, bei dem die weiteren Durchkontaktierungen (9) eine oberste Verdrahtungsebene (7) aus Kupfer kontaktieren.

5. Anordnung mit einem Halbleiterchip, bei der
der Halbleiterchip (10) mindestens eine Verdrahtungsebene (4), mindestens ein Zwischenmetalldielektrikum (5) und Durchkontaktierungen (6) sowie Anschlusskontaktflächen (1) zur externen elektrischen Verbindung aufweist,
wobei auf einer obersten Verdrahtungsebene (7) eine Passivierungsschicht (8) vorhanden ist, die mit weiteren Durchkontaktierungen (9) versehen ist, und
auf der Passivierungsschicht (8) die Anschlusskontaktflächen (1) angeordnet und mit den betreffenden weiteren Durchkontaktierungen (9) verbunden sind,
der Halbleiterchip (10) auf einem Träger (20) angebracht ist, der Träger (20) weitere Anschlusskontaktflächen (2) aufweist und
die Anschlusskontaktflächen (1) des Halbleiterchips (10) mit zugeordneten weiteren Anschlusskontaktflächen (2) des Trägers (20) dauerhaft elektrisch leitend verbunden sind
**dadurch gekennzeichnet, dass**
mindestens eine Anschlusskontaktfläche (1) des Halbleiterchips (10) und die zugeordnete weitere Anschlusskontaktfläche (2) des Trägers (20) ringförmig oder rahmenförmig ausgebildet und so zueinander ausgerichtet sind, dass sie einander in einem ringförmigen oder rahmenförmigen Bereich oder zumindest in zwei voneinander getrennten Bereichen berühren.

## Claims

1. Semiconductor chip comprising
at least one wiring level (4), at least one intermetal dielectric (5) and vias (6) and also comprising
contact pads (1) for external electrical connection,
wherein a passivation layer (8) is present on a topmost wiring level (7), said passivation layer being provided with further vias (9), and
the contact pads (1) are arranged on the passivation layer (8) and are connected to the relevant further vias (9),
**characterized in that**
at least one contact pad (1) is formed in ring-shaped fashion or in frame-shaped fashion.

2. Semiconductor chip according to Claim 1, in which the contact pads (1) have a dimensioning that deviates from a structure of each wiring level (4) and recurs periodically at least in one direction.

3. Semiconductor chip according to Claim 1 or 2, in which
at least one contact pad (1) is formed in strip-shaped fashion.

4. Semiconductor chip according to any of Claims 1 to 3, in which
the further vias (9) make contact with a topmost wiring level (7) composed of copper.

5. Arrangement comprising a semiconductor chip, in which
the semiconductor chip (10) has at least one wiring level (4), at least one intermetal dielectric (5) and vias (6) and also contact pads (1) for external electrical connection,
wherein a passivation layer (8) is present on a topmost wiring level (7), said passivation layer being provided with further vias (9), and
the contact pads (1) are arranged on the passivation layer (8) and are connected to the relevant further vias (9),
the semiconductor chip (10) is fitted on a carrier (20),
the carrier (20) has further contact pads (2), and
the contact pads (1) of the semiconductor chip (10) are permanently electrically conductively connected to assigned further contact pads (2) of the carrier (20),
**characterized in that**
at least one contact pad (1) of the semiconductor chip (10) and the assigned further contact pad (2) of the carrier (20) are formed in ring-shaped fashion or in frame-shaped fashion and are oriented with respect to one another in such a way that they touch one another in a ring-shaped or frame-shaped region or at least in two mutually separate regions.

## Revendications

1. Puce à semi-conducteur comprenant
au moins un plan ( 4 ) de câblage, au moins un diélectrique ( 5 ) métallique intermédiaire et des traversées ( 6 ), ainsi que
des surfaces ( 1 ) de contact de borne pour la liaison électrique avec l'extérieur,
dans laquelle il y a, sur un plan ( 7 ) de câblage le plus haut, une couche ( 8 ) de passivation qui est munie de traversées ( 9 ) supplémentaires, et
les surfaces ( 1 ) de contact de borne sont disposées sur la couche ( 8 ) de passivation et sont reliées aux traversées ( 9 ) supplémentaires concernées,
**caractérisée en ce que**
au moins une surface ( 1 ) de contact de borne est annulaire ou en forme de cadre.

2. Puce à semi-conducteur suivant la revendication 1, dans laquelle
les surfaces ( 1 ) de contact de borne ont une dimension s'écartant d'une structure de chaque plan ( 4 ) de câblage et se répétant périodiquement au moins dans une direction.

3. Puce à semi-conducteur suivant la revendication 1 ou 2, dans laquelle
au moins une surface ( 1 ) de contact de borne est en forme de bande.

4. Puce à semi-conducteur suivant l'une des revendications 1 à 3, dans laquelle
les traversées ( 9 ) supplémentaires entrent en contact avec un plan ( 7 ) de câblage le plus haut en cuivre.

5. Dispositif comprenant une puce à semi-conducteur, dans lequel
la puce ( 10 ) à semi-conducteur a au moins un plan ( 4 ) de câblage, au moins un diélectrique ( 5 ) métallique intermédiaire et des traversées ( 6 ), ainsi que des surfaces ( 1 ) de contact de borne pour la liaison électrique avec l'extérieur,
dans lequel il y a, sur un plan ( 7 ) de câblage le plus haut, une couche ( 8 ) de passivation qui est munie de traversées ( 9 ) supplémentaires, et
les surfaces ( 1 ) de contact de borne sont disposées sur la couche ( 8 ) de passivation et sont reliées aux traversées ( 9 ) supplémentaires concernées,
la puce ( 10 ) à semi-conducteur est mise sur un support ( 20 ),
le support ( 20 ) a des surfaces ( 2 ) de contact de borne supplémentaires, et
les surfaces ( 1 ) de contact de borne de la puce ( 10 ) à semi-conducteur sont reliées en permanence d'une manière conductrice de l'électricité à des surfaces ( 2 ) de contact de borne supplémentaires du support (20) qui leur sont associées,
**caractérisé en ce que**
au moins une surface ( 1 ) de contact de borne de la puce ( 10 ) à semi-conducteur et la surface ( 2 ) de contact de borne supplémentaire associée du support ( 20 ) sont annulaires ou en forme de cadre et sont dirigées l'une par rapport à l'autre de manière à se toucher l'une l'autre dans une partie annulaire ou en forme de cadre ou au moins dans deux parties séparées l'une de l'autre.
